(19) Europäisches Patentamt
European Patent Office
Office européen des brevets

(11) **EP 2 523 350 B1**

(12) **EUROPEAN PATENT SPECIFICATION**

(45) Date of publication and mention
of the grant of the patent:
**30.10.2013 Bulletin 2013/44**

(51) Int Cl.:
**H03L 7/085** (2006.01)   **H03L 7/10** (2006.01)
**H03L 7/18** (2006.01)

(21) Application number: **11165809.2**

(22) Date of filing: **12.05.2011**

(54) **A clock generation system**

Takterzeugungssystem

Un système de génération d'horloge

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**14.11.2012 Bulletin 2012/46**

(73) Proprietor: **Siemens Aktiengesellschaft
80333 München (DE)**

(72) Inventor: **Burcea, George
Ajax  ON L1T 4P6 (CA)**

(56) References cited:
**US-A1- 2008 197 897**

• **MENG-TING TSAI ET AL: "A Fast-Locking Agile
Frequency Synthesizer for MIMO Dual-mode WiFi
/ WiMAX Applications", ELECTRONICS,
CIRCUITS AND SYSTEMS, 2007. ICECS 2007.
14TH IEEE INTERNATIONAL CONFERENCE ON,
IEEE, PISCATAWAY, NJ, USA, 11 December 2007
(2007-12-11), pages 1384-1387, XP031248520,
ISBN: 978-1-4244-1377-5**
• **TSUNG-HSIEN LIN ET AL: "An Agile VCO
Frequency Calibration Technique for a 10-GHz
CMOS PLL", IEEE JOURNAL OF SOLID-STATE
CIRCUITS, IEEE SERVICE CENTER,
PISCATAWAY, NJ, USA, vol. 42, no. 2, 1 February
2007 (2007-02-01), pages 340-349, XP011161673,
ISSN: 0018-9200, DOI: 10.1109/JSSC.
2006.889360**

**Description**

The present invention relates to a clock generation system for generating a first clock signal at a first clock frequency and a second clock signal at a second clock frequency with a predetermined ratio to said first clock frequency, said system comprising:

- a clock signal generator providing a first clock signal at a first clock frequency (f),
- a first frequency divider dividing the first clock frequency by a first integer (N) to produce a first auxiliary signal,
- a second frequency divider dividing a second clock frequency by a second integer (K) to produce a second auxiliary signal,
- a comparator for providing an error signal by comparing the first and second auxiliary signals, and
- a voltage-controlled oscillator controlled in dependence on said error signal to generate said second clock signal.

Such a system is known from EP 2 207 263 A1.

The comparator, voltage-controlled oscillator and second frequency divider form a phase-locked loop (PLL) which locks onto a multiple, K, of its input frequency f/N so that the ratio of said second and first clock frequencies is K/N.

In practice, the frequencies of the first and second clock frequencies may be only slightly different, e.g. 3.000000 MHz and 2.999970 MHz which requires the integer divisors N = 300000 and K = 299997. Thus, a major disadvantage of the prior art clock generation system may be the long response time because the frequency multiplication is performed by the PLL and each frequency adjustment can only be made after the two signals are checked around the coincidence moment when N periods of the first clock signal = K periods of the second clock signal. Several corrections are necessary to lock the PLL, and when large N and K divider ratios are required, it takes a very long time to bring the PLL into lock.

Meng- Ting Tsai et al: "A Fast- Locking Agile Frequency Synthesizer for MIMO Dual- mode WiFi / WiMAX Applications", Electronics, Circuits and Systems, 2007, ICECS 2007, 14th IEEE International Conference on, 11.12.2007, pages 1384- 1387, disclose a frequency synthesizer with a wide frequency range. The synthesizer architecture consists of a phase- locked loop (PLL) for fine tuning and a calibration loop for coarse tuning. The PLL comprises a voltage-controlled oscillator (VCO), a frequency divider and a phase detector. The calibration loop comprises the VCO, the frequency divider in- line with a further frequency divider, a timer, a comparator, a counter and a capacitor array for coarse tuning the VCO. The timer comprises a time- to- voltage converter which measures the period differences between a reference clock and the frequency divided clock. The comparator switches the synthesizer either to the phase- locked loop or the calibration loop. During the calibration, the counter accumulates the reference and the divided frequency cycles. The capacitor array is controlled according to the counting result to select and set the frequency band. Afterwards, the frequency synthesizer switches to the phase- locked loop.

US 2008/0197897 A1 discloses a similar PLL circuit with a voltage-controlled oscillator, a frequency divider and a first and second phase comparator. Both phase comparators compare the phase/period of the divided signal with that of a reference signal; the second phase comparator additionally averages the detected phase difference with respect to time. This allows for coarse and fine-tuning of the PLL.

It is an object of the invention to overcome the prior art drawbacks and to provide two clock signals of slightly different frequencies with defined time or phase delay.

According to the invention this object is achieved in that

- the clock generation system of the initially mentioned kind further comprises a timer for measuring a first time lag between a first signal edge of the first auxiliary signal and a first signal edge of the second auxiliary signal and for measuring a second time lag between a second signal edge of the first auxiliary signals and a second signal edge of the second auxiliary signal, and that
- the comparator means is adapted to provide the error signal by comparing the difference between the measured time lags with a predetermined time value.

Thus, the ratio of the first and second clock frequencies no longer only depends on the first and second integers but also on the predetermined time value which allows for finer adjustment of the difference of the frequencies at lower values of the first and second integers. As a result, the loop lock time is shorter because the adjustment of the frequency of the voltage- controlled oscillator is made after a much shorter time than the time to reach coincidence between the first and second clock signal.

Any error, such as propagation delay variation, offset and slope errors, occurring in the signal processing chain between the frequency dividers and the comparator means where the difference between the measured time lags is determined will equally affect both time lags and thus will be cancelled by the subtraction of the time lags.

In a preferred embodiment of the system according to the invention, the timer comprises a time-to-voltage converter which offers a high time resolution.

The predetermined time value may be easily obtained by temporarily switching the system in an adjustment mode wherein the first clock signal instead of the second clock signal is connected to the second frequency divider, and wherein the difference between the time lags measured in the adjustment mode is multiplied by a factor to obtain said predetermined time value. This adjustment mode may be repeated regularly or from time to time in order to compensate for component variations due to temperature changes or aging.

The first and second frequency dividers may be adapted to adjust the first and second integers in order to optimize the gain of the phase-locked loop and get a sufficiently high error signal.

The invention will be now further described by way of preferred example and with reference to the accompanying drawing, in which:

Figure 1         shows a block diagram of the clock generation system according to the invention,

Figure 2         is a timing diagram showing signals generated by the clock generation system,

Figure 3         is an example of a time-to-voltage converter being part of the clock generation system shown in Figure 1,

Figure 4         is a first example of a comparator means being part of the clock generation system shown in Figure 1,

Figure 5         is a second example of the comparator means,

Figure 6         is a further embodiment of the clock generation system according to the invention, and

Figures 7 and 8     are further examples of a timing scheme for the signals generated by the clock generation system, and

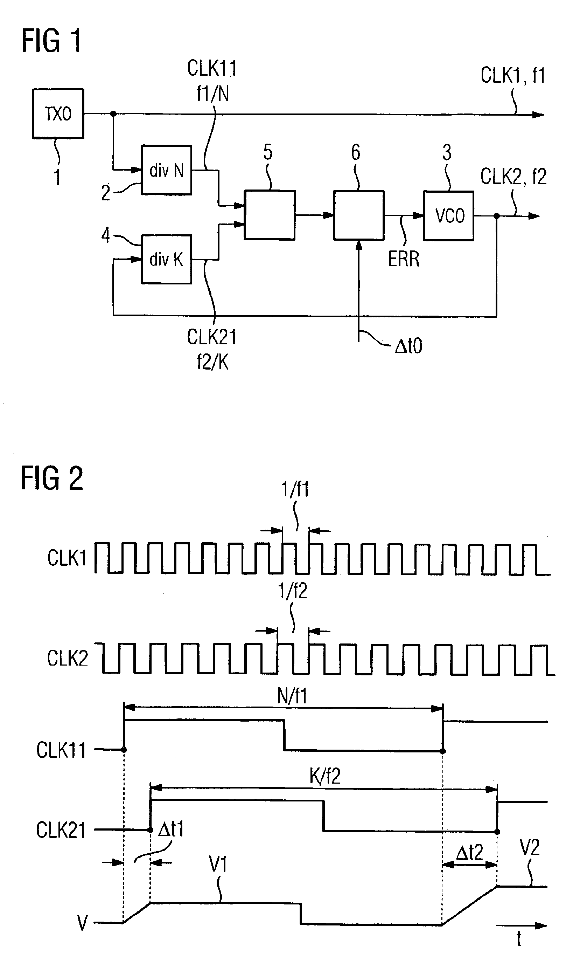

Figure 1 shows a clock generation system in which a clock signal generator 1 provides a first clock signal CLK1 of a first clock frequency f1. A first frequency divider 2 divides the first clock frequency f1 by a first integer N to produce a first auxiliary signal CLK11. A second clock signal CLK2 with a second clock frequency f2 is generated by a voltage-controlled oscillator (VCO) 3 and, in a second frequency divider 4, divided by a second integer K to produce a second auxiliary signal CLK21. As described below in more detail, a timer 5 measures a first time lag between first signal edges of the first and second auxiliary signals CLK11, CLK21 and after that a second time lag between second signal edges of the first and second auxiliary signals CLK11, CLK21. A comparator means 6 generates an error signal ERR by comparing the difference between the measured time lags with a predetermined time value $\Delta t0$. The error signal ERR is fed, e.g. through a PLL loop filter (not shown), to the voltage-controlled oscillator 3 which generates the second clock signal CLK2.

Figure 2 shows a timing diagram of the signals CLK1, CLK2, CLK11 and CLK21. The first clock signal CLK1 has a period of $1/f1$ and the second clock signal CLK2 has a period of $1/f2$. Due to the frequency division by N and K respectively, the first auxiliary signal CLK11 has a period of $N/f1$ and the second auxiliary signal CLK21 has a period of $K/f2$. In the shown example, the timer 5 measures the first time lag $\Delta t1$ between a rising signal edge of the first auxiliary signal CLK11 and the following rising signal edge of the second auxiliary signal CLK21. One period of the first auxiliary signal CLK11 later, the timer 5 measures the second time lag $\Delta t2$ between the rising signal edge of the first auxiliary signal CLK11 and the following rising signal edge of the second auxiliary signal CLK21. Alternatively, the falling signal edges may be used instead of the rising edges. Thus, following equation is obtained:

$$N/f1 + \Delta t2 = K/f2 + \Delta t1$$

or

$$K/f2 - N/f1 = \Delta t2 - \Delta t1.$$

The comparator means 6 compares the time lag difference $\Delta t1 - \Delta t2$ with a predetermined time value $\Delta t0$ and generates, on the basis of this comparison, the error signal ERR for controlling the voltage-controlled oscillator 3. Thus, the PLL being comprised of the components 3 to 6 controls the time lag difference $\Delta t1 - \Delta t2$ at the constant time value $\Delta t0$ so that the ratio of the first and second clock frequencies f1 and f2 no longer only depends on the first and second integers n and K but also on the predetermined time value $\Delta t0$.

For example, in the prior art, first and second clock frequencies of f1 = 3.000000 MHz and f2 = 2.999970 MHz ((f1 - f2)/f1 = 10ppm) require the integer divisors N = 300000 and K = 299997.

The same frequencies are generated by the clock generation system of Figure 1 operating according to timing diagram of Figure 2 and having the following parameters:

$$N = K = 1000$$

and

$$\begin{aligned} \Delta t0 &= K/f2 - N/f1 \\ &= N \cdot [(f1 - f2)/f1] \cdot 1/f2 \\ &= 1000 \cdot 10ppm \cdot 1/f2 \\ &= 1\% \cdot 1/f2. \end{aligned}$$

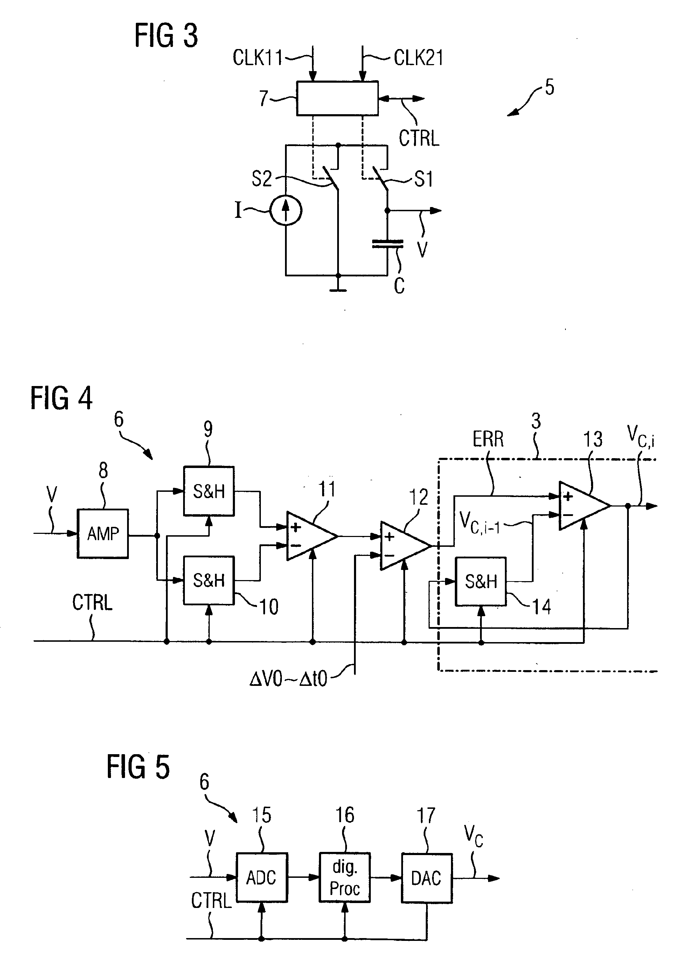

Figure 3 shows a simplified example of the timer 5 which comprises a time-to-voltage converter. The time-to-voltage converter has a constant current source I in series with a capacitor C and a first switch S1. A second switch S2 is in parallel with the constant current source I. The switches S1 and S2 are controlled by the first and auxiliary signals CLK11 and CLK21 via a logic block 7. The first switch S1 is turned on by each rising edge of the first signal CLK11 and turned off by each rising edge of the second signal CLK21. The second switch S2 is turned on for a short time when the first switch S1 is open. Each time the first switch S1 is closed the capacitor C is charged to a voltage V which is proportional to the respective time lags $\Delta t1$ and $\Delta t2$:

$$V1 = G \cdot \Delta t1 \text{ and } V2 = G \cdot \Delta t2.$$

Figure 2 shows the voltage V over the capacitor C.

Figure 4 shows a first example of a mixed analog and digital design of the comparator means 6 together with an input section of the voltage-controlled oscillator 3. The voltage values V1, V2 provided by the time-to-voltage converter (timer 5) are amplified by an amplifier 8 and buffered in sample-and-hold circuits 9, 10. Two differential amplifiers 11 and 12 produce the error signal:

$$ERR = (V2 - V1) - \Delta V0,$$

where $V2 \sim \Delta t2$, $V1 \sim \Delta t1$ and $\Delta V0 \sim \Delta t0$, so that:

$$ERR \sim (\Delta t2 - \Delta t1) - \Delta t0.$$

The input section of the voltage-controlled oscillator 3 comprises another differential amplifier 13 whose output is fed back through a sample-and-hold circuit 14 to its one input and which receives at the other input the error signal ERR. After every two measurements, the control voltage $V_c$ of the voltage-controlled oscillator 3 is adjusted by an amount proportional with ERR so that it changes from the previous value $V_{c,i-1}$ to a new value $V_{c,i}$, where $V_{c,i} = V_{c,i-1} - k \cdot ERR$. This way, the voltage-controlled oscillator 3 is successively adjusted to bring and maintain the frequencies f1 and f2 in the relation K/f2 - N/f1 = $\Delta t0$.

The timing of the components 9 to 14 is controlled by a control signal CTRL provided by the logic block 7 of the timer 5 (Figure 3).

Figure 5 shows an alternative example of the above-described comparator means 6 where the amplifier 8 and sample-and-hold circuits 9, 10 are replaced by an analog-to-digital converter 15 and where the differential amplifiers 11, 12, 13 and the sample-and-hold circuit 14 are replaced by a digital processor 16 and digital-to-analog converter 17. In all other respects the comparator means 6 works similar as described above.

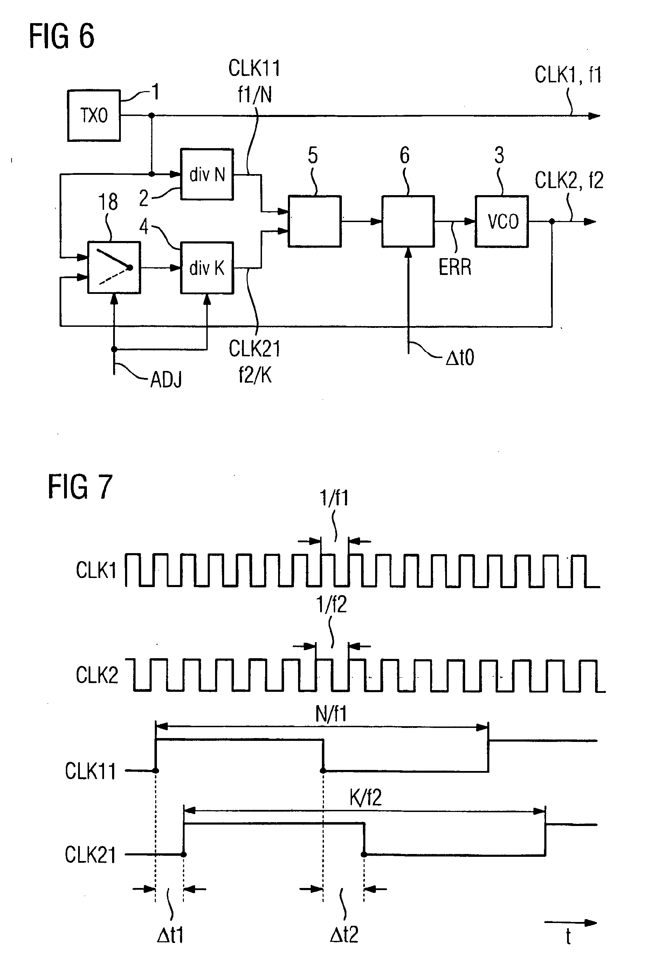

Figure 6 shows a further embodiment of the clock generation system which differs from that of Figure 1 in that a changeover switch or two-to-one multiplexer 18 is provided for either connecting the first clock signal CLK1 or the second clock signal CLK2 to the second frequency divider 4. In a calibration or adjustment mode, the switch 18 is controlled by a control signal ADJ to connect the first clock signal CLK1 to the second frequency divider 4. This gives the following equation:

$$N/f1 + \Delta t2' = K/f1 + \Delta t1'$$

or

$$(K - N)/f1 = \Delta t2' - \Delta t1' = \Delta t0'.$$

Thus, the comparator means 6 measures the time lag difference $\Delta t0'$ and the differential amplifier 11 outputs a voltage $\Delta V0' \sim \Delta t0'$. This value $\Delta t0'$ or $\Delta V0'$ is now multiplied by a suitable factor x to obtain the predetermined time value $\Delta t0 = x \cdot \Delta t0'$ or $\Delta V0 = x \cdot \Delta V0'$. The system is now switched back to the normal clock generation mode in that the second clock signal CLK2 is given to the second frequency divider 4, wherein:

$$K/f2 - N/f1 = \Delta t2 - \Delta t1 = x \cdot \Delta t0' = x \cdot (K - N)/f1$$

or

$$f2/f1 = (K/N)/(x \cdot K/N + 1 - x)$$

or

$$x = [(K/N) \cdot (f1/f2) - 1]/[(K/N) - 1].$$

For, e.g., K = 2N or K/N = 2 one obtains:

$$f2/f1 = 2/(1 + x)$$

or

$$x = 2f1/f2 - 1.$$

Figure 7 shows another timing scheme for the signals CLK1, CLK2, CLK11 and CLK21 which differs from that of Figure 2 in that the timer 5 successively measures the first time lag $\Delta t1$ between the rising signal edges of the auxiliary signal CLK11, CLK21 and the second time lag $\Delta t2$ between the following falling signal edges of the auxiliary signals CLK11, CLK21. This gives the following relationship:

$$N/2f1 + \Delta t2 = K/2f2 + \Delta t1$$

or

$$K/2f2 - N/2f1 = \Delta t2 - \Delta t1.$$

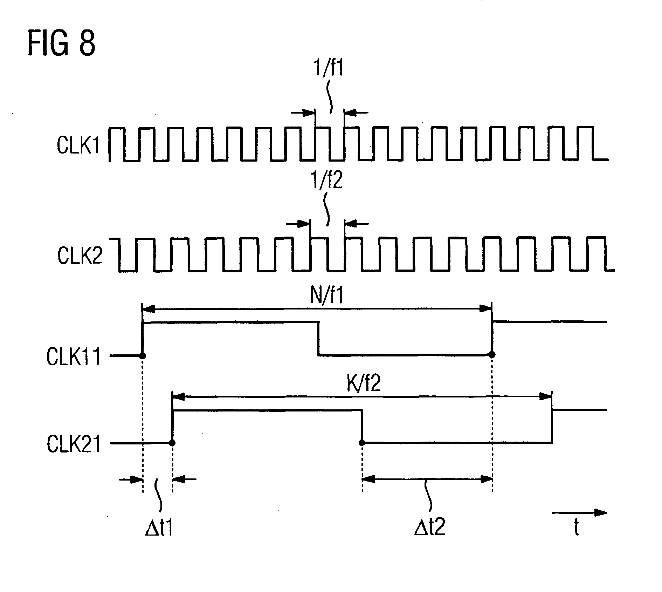

Figure 8 shows yet another timing scheme for the signals CLK1, CLK2, CLK11 and CLK21 which differs from that of Figures 2 and 6 in that the timer 5 first measures the first time lag $\Delta t1$ between the rising signal edges of the auxiliary signal CLK11, CLK21 and after that the second time lag $\Delta t2$ between the following falling signal edge of the second auxiliary signal CLK21 and the following rising signal edge of the first auxiliary signal CLK21. This gives:

$$N/f1 = K/2f2 + \Delta t1+ \Delta t2$$

or

$$N/f1 - K/2f2 = \Delta t1 + \Delta t2.$$

The time lags $\Delta t1$ and $\Delta t2$ are further processed in the same way as described above with reference to Figures 2 to 5. This means the comparator means 6 compares the time lag difference $\Delta t1 - \Delta t2$ with a predetermined time value $\Delta t0$ and generates, on the basis of this comparison, the error signal ERR for controlling the voltage-controlled oscillator 3. In the case of the timing scheme of Figure 7, the second time lag $\Delta t2$ is actually negative which in practice makes the difference $\Delta t1 - \Delta t2$ a summation. Therefore, the differential amplifier 11 of Figure 4 is replaced by a summation amplifier.
The divider factors N and K of the frequency dividers 2 and 4 may be variable to allow for progressive gain adjustment when generating the error signal ERR. At the beginning of the adjustment cycle the error signal ERR is expected to have a large value so that large gain is not necessary, and the divider factors may be set to lower values, for example 100. This allows proper signal scaling and avoids saturation. As the voltage-controlled oscillator 3 is adjusted the value of the error signal ERR decreases and the loop gain can be increased using larger divider factors N and K, for example 1000. After the second clock frequency f2 is brought even closer to the target value the divider factors N, K can be increased once more, 10000 for example, and have increased sensitivity to maintain the second clock frequency f2 at the desired value. Changing the divider factors N, K is equivalent with changing the gain for the error signal ERR.

**Claims**

1.   A clock generation system for generating a first clock signal (CLK1) at a first clock frequency (f1) and a second clock signal (CLK2) at a second clock frequency (f2) with a predetermined ratio to said first clock frequency (f1), said system comprising:

- a clock signal generator (1) for providing the first clock signal (CLK1) at the first clock frequency (f1),
- a first frequency divider (2) for dividing the first clock frequency (f1) by a first integer (N) to produce a first auxiliary signal (CLK11),
- a second frequency divider (4) for dividing the second clock frequency (f2) by a second integer (K) to produce a second auxiliary signal (CLK21),
- a comparator means (6) for providing an error signal (ERR) by comparing the first and second auxiliary signals (CLK11, CLK21), and
- a voltage- controlled oscillator (3) being controlled in dependence on said error signal (ERR) to generate said second clock signal (CLK2),
**characterized in that**
- the system further comprises a timer (5) for measuring a first time lag ($\Delta t1$) between a first signal edge of the first auxiliary signal (CLK11) and a first signal edge of the second auxiliary signal (CLK21) and for measuring a second time lag (Δt2) between a second signal edge of the first auxiliary signals (CLK11) and a second signal edge of the second auxiliary signal (CLK21), and that

- the comparator means (6) is adapted to provide the error signal (ERR) by comparing the difference between the measured time lags (Δt1, Δt2) with a predetermined time value (Δt0).

2. The clock generation system of claim 1, wherein the timer (5) comprises a time-to-voltage converter.

3. The clock generation system of claim 1 or 2, further comprising a switch (18) for connecting, in an adjustment mode of the system, the first clock signal (CLK1) instead of the second clock signal (CLK2) to the second frequency divider (4), and wherein the difference between the time lags (Δt1, Δt2) measured in the adjustment mode is multiplied by a factor (x) to obtain the predetermined time value (Δt0).

4. The clock generation system of any of the preceding claims, wherein the first and second frequency dividers (2, 4) are adapted to adjust the first and second integers (N, K) .


**Patentansprüche**

1. Takterzeugungssystem zum Erzeugen eines ersten Taktsignals (CLK1) bei einer ersten Taktfrequenz (f1) und eines zweiten Taktsignals (CLK2) bei einer zweiten Taktfrequenz (f2) mit einem vorbestimmten Verhältnis zu der ersten Taktfrequenz (f1), wobei das System Folgendes aufweist:

- einen Taktsignalgenerator (1) zum Bereitstellen des ersten Taktsignals (CLK1) bei der ersten Taktfrequenz (f1),
- einen ersten Frequenzteiler (2) zum Teilen der ersten Taktfrequenz (f1) durch eine erste Ganzzahl (N) zum Erzeugen eines ersten Hilfssignals (CLK11),
- einen zweiten Frequenzteiler (4) zum Teilen der zweiten Taktfrequenz (f2) durch eine zweite Ganzzahl (K) zum Erzeugen eines zweiten Hilfssignals (CLK21),
- ein Komparatormittel (6) zum Bereitstellen eines Fehlersignals (ERR) durch Vergleichen des ersten und des zweiten Hilfssignals (CLK11, CLK21), und
- einen spannungsgesteuerten Oszillator (3), der in Abhängigkeit von dem Fehlersignal (ERR) gesteuert wird, um das zweite Taktsignal (CLK2) zu erzeugen, **dadurch gekennzeichnet, dass**:
- das System ferner einen Zeitmesser (5) zum Messen einer ersten zeitlichen Verzögerung (Δt1) zwischen einer ersten Signalflanke des ersten Hilfssignals (CLK11) und einer ersten Signalflanke des zweiten Hilfssignals (CLK21) und zum Messen einer zweiten zeitlichen Verzögerung (Δt2) zwischen einer zweiten Signalflanke des ersten Hilfssignals (CLK11) und einer zweiten Signalflanke des zweiten Hilfssignals (CLK21) aufweist, und dass:
- das Komparatormittel (6) angepasst ist, um das Fehlersignal (ERR) durch Vergleichen der Differenz zwischen den gemessenen zeitlichen Verzögerungen (Δt1, Δt2) mit einem vorbestimmten Zeitwert (Δt0) bereitzustellen.

2. Takterzeugungssystem nach Anspruch 1, wobei der Zeitmesser (5) einen Zeit/Spannungswandler aufweist.

3. Takterzeugungssystem nach Anspruch 1 oder 2, das ferner einen Schalter (18) aufweist, um in einem Einstellungsbetriebsmodus des Systems das erste Taktsignal (CLK1) anstatt des zweiten Taktsignals (CLK2) mit dem zweiten Frequenzteiler (4) zu verbinden, und wobei die Differenz zwischen den im Einstellungsbetriebsmodus gemessenen zeitlichen Verzögerungen (Δt1, Δt2) mit einem Faktor (x) multipliziert wird, um den vorbestimmten Zeitwert (Δt0) zu erhalten.

4. Takterzeugungssystem nach einem der vorhergehenden Ansprüche, wobei der erste und der zweite Frequenzteiler (2, 4) angepasst sind, um die erste und die zweite Ganzzahl (N, K) einzustellen.


**Revendications**

1. Système de production d'horloge pour produire un premier signal ( CLK1 ) d'horloge à une première fréquence ( f1 ) d'horloge et un deuxième signal ( CLK2 ) à une deuxième fréquence ( f2 ) d'horloge ayant un rapport déterminé à l'avance avec la première fréquence ( f1 ) d'horloge, le système comprenant :

- un générateur ( 1 ) de signal d'horloge pour fournir le premier signal ( CLK1 ) d'horloge à la première fréquence ( f1 ) d'horloge,

- un premier diviseur ( 2 ) de fréquence pour diviser la première fréquence ( f1 ) d'horloge par un premier nombre ( N ) entier pour produire un premier signal ( CLK1 ) auxiliaire,

- un deuxième diviseur ( 4 ) de fréquence pour diviser la deuxième fréquence ( f2 ) d'horloge par un deuxième nombre ( K ) entier pour produire un deuxième signal ( CLK21 ) auxiliaire,

- un moyen ( 6 ) formant comparateur pour fournir un signal ( ERR ) d'erreur en comparant le premier signal ( CLK11 ) auxiliaire et le deuxième signal ( CLK21 ) auxiliaire, et

- un oscillateur ( 3 ) commandé en tension, en fonction du signal ( ERR ) d'erreur, pour produire le deuxième signal ( CLK2 ) d'horloge,

**caractérisé en ce que**

- le système comprend, en outre, une minuterie ( 5 ) pour mesurer un premier retard ( $\Delta$t1 ) entre un premier flanc du premier signal ( CLK11 ) auxiliaire et un premier flanc du deuxième signal ( CLK21 ) auxiliaire et pour mesurer un deuxième retard ( $\Delta$t2 ) entre un deuxième flanc du premier signal ( CLK11 ) auxiliaire et un deuxième flanc du deuxième signal ( CLK21 ) auxiliaire, et **en ce que**

- les moyens ( 6 ) formant comparateur sont conçus pour fournir le signal ( ERR ) d'erreur, en comparant la différence entre les retards ( $\Delta$t1, $\Delta$t2 ) mesurés à une valeur ( $\Delta$t0 ) de temps déterminée à l'avance.

2. Système de production d'horloge suivant la revendication 1, dans lequel la minuterie ( 5 ) comprend un convertisseur temps à tension.

3. Système de production d'horloge suivant les revendications 1 ou 2, comprenant, en outre, un commutateur ( 18 ) pour appliquer, dans un mode d'ajustement du système, le premier signal ( CLK1 ) d'horloge au lieu du deuxième signal ( CLK2 ) d'horloge au deuxième diviseur ( 4 ) de fréquence, et dans lequel la différence entre les retards ( $\Delta$t1, $\Delta$t2 ) mesurés dans le mode d'ajustement est multipliée par un facteur ( x ) pour obtenir la valeur ( $\Delta$t0 ) de temps déterminée à l'avance.

4. Système de production d'horloge suivant l'une des revendications précédentes, dans lequel les premier et deuxième diviseurs ( 2, 4 ) de fréquence sont conçus pour ajuster les premier et deuxième nombres ( N, K ) entiers.

FIG 1

FIG 2

## FIG 3

## FIG 4

## FIG 5

## FIG 6

CLK11
f1/N

CLK1, f1

1 TX0

2 div N

18

4 div K

5

6

3 VCO

CLK2, f2

ERR

Δt0

ADJ

CLK21
f2/K

## FIG 7

1/f1

CLK1

1/f2

CLK2

N/f1

CLK11

K/f2

CLK21

Δt1

Δt2

t

FIG 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2207263 A1

- US 20080197897 A1

**Non-patent literature cited in the description**

- **MENG-TING TSAI et al.** A Fast-Locking Agile Frequency Synthesizer for MIMO Dual-mode WiFi / WiMAX Applications. *Electronics, Circuits and Systems, 2007, ICECS 2007, 14th IEEE International Conference,* 11 December 2007, 1384-1387